# EUROPEAN PATENT SPECIFICATION

(11) **EP 1 820 285 B1**
(45) Date of publication and mention of the grant of the patent: **08.03.2017**
(21) Application number: 05824517.6
(22) Date of filing: 08.11.2005
(51) Int. Cl.: H04B 3/32

(54) **COMMUNICATIONS CONNECTOR WITH FLOATING WIRING BOARD FOR IMPARTING CROSSTALK COMPENASTION BETWEEN CONDUCTORS**
KOMMUNIKATIONSVERBINDER MIT ERDFREIER LEITERPLATTE ZUM VERMITTELN VON ÜBERSPRECHKOMPENSATION ZWISCHEN LEITERN
CONNECTEUR DE COMMUNICATION COMPORTANT UNE CARTE DE CONNEXION FLOTTANTE PERMETTANT DE COMPENSER LA DIAPHONIE ENTRE DE CABLES

(30) Priority: 07.12.2004 US 633783 P; 16.12.2004 US 636590 P; 16.12.2004 US 636595 P; 28.01.2005 US 648002 P; 27.05.2005 US 139768
(43) Date of publication of application: 22.08.2007
(73) Proprietor: COMMSCOPE INC. OF NORTH CAROLINA, Hickory, North Carolina 28601 (US)
(72) Inventor: HASHIM, Amid, Plano, Texas 75093 (US)
(74) Representative: Popp, Eugen
(86) International application number: PCT/US2005/040583
(87) International publication number: WO 2006/062662

(56) References cited:
- EP-A- 0 901 201
- WO-A-03/090322
- US-A1- 2001 021 608
- US-B1- 6 270 381

## Description

### Field of the Invention

The present invention relates generally to communication connectors and more particularly to near-end crosstalk (NEXT) and far-end crosstalk (FEXT) compensation in communication connectors.

### Background of the Invention

In an electrical communication system, it is sometimes advantageous to transmit information signals (video, audio, data) over a pair of wires (hereinafter "wire-pair" or "differential pair") rather than a single wire, wherein the transmitted signal comprises the voltage difference between the wires without regard to the absolute voltages present. Each wire in a wire-pair is susceptible to picking up electrical noise from sources such as lightning, automobile spark plugs and radio stations to name but a few. Because this type of noise is common to both wires within a pair, the differential signal is typically not disturbed. This is a fundamental reason for having closely spaced differential pairs.

Of greater concern, however, is the electrical noise that is picked up from nearby wires or pairs of wires that may extend in the same general direction for some distances and not cancel differentially on the victim pair. This is referred to as crosstalk. Particularly, in a communication system involving networked computers, channels are formed by cascading plugs, jacks and cable segments. In such channels, a modular plug often mates with a modular jack, and the proximities and routings of the electrical wires (conductors) and contacting structures within the jack and/or plug also can produce capacitive as well as inductive couplings that generate near-end crosstalk (NEXT) (i.e., the crosstalk measured at an input location corresponding to a source at the same location) as well as far-end crosstalk (FEXT) (i.e., the crosstalk measured at the output location corresponding to a source at the input location). Such crosstalks occur from closely-positioned wires over a short distance. In all of the above situations, undesirable signals are present on the electrical conductors that can interfere with the information signal. When the same noise signal is added to each wire in the wire-pair, the voltage difference between the wires will remain about the same and differential cross-talk is not induced, while at the same time the average voltage on the two wires with respect to ground reference is elevated and common mode crosstalk is induced. On the other hand, when an opposite but equal noise signal is added to each wire in the wire pair, the voltage difference between the wires will be elevated and differential crosstalk is induced, while the average voltage on the two wires with respect to ground reference is not elevated and common mode crosstalk is not induced.

U.S. Pat. No. 5,997,358 to Adriaenssens et al. (hereinafter "the '358 patent") describes a two-stage scheme for compensating differential to differential NEXT for a plug-jack combination. Connectors described in the '358 patent can reduce the internal NEXT (original crosstalk) between the electrical wire pairs of a modular plug by adding a fabricated or artificial crosstalk, usually in the jack, at one or more stages, thereby canceling or reducing the overall crosstalk for the plug-jack combination. The fabricated crosstalk is referred to herein as a compensation crosstalk. This idea can often be implemented by twice crossing the path of one of the differential pairs within the connector relative to the path of another differential pair within the connector, thereby providing two stages of NEXT compensation. This scheme can be more efficient at reducing the NEXT than a scheme in which the compensation is added at a single stage, especially when the second and subsequent stages of compensation include a time delay that is selected to account for differences in phase between the offending and compensating crosstalk. This type of arrangement can include capacitive and/or inductive elements that introduce multi-stage crosstalk compensation, and is typically employed in jack lead frames and PWB structures within jacks. These configurations can allow connectors to meet "Category 6" performance standards set forth in ANSI/EIA/TIA 568, which are primary component standards for mated plugs and jacks for transmission frequencies up to 250MHz.

Alien NEXT is the differential crosstalk that occurs between communication channels. Obviously, physical separation between jacks will help and/or typical crosstalk approaches may be employed. However, a problem case may be "pair 3" of one channel crosstalking to "pair 3" of another channel, even if the pair 3 plug and jack wires in each channel are remote from each other and the only coupling occurs between the routed cabling. To reduce this form of alien NEXT, shielded systems containing shielded twisted pairs or foiled twisted pair configurations may be used. However, the inclusion of shields can increase cost of the system. Another approach to reduce or minimize alien NEXT utilizes spatial separation of cables within a channel and/or spatial separation between the jacks in a channel. However, this is typically impractical because bundling of cables and patch cords is common practice due to "real estate" constraints and ease of wire management.

In spite of recent strides made in improving mated connector (i.e., plug-jack) performance, and in particular reducing crosstalk at elevated frequencies (e.g., 500 MHz - see U.S. Patent Application Serial No. 10/845,104, entitled NEXT High Frequency Improvement by Using Frequency Dependent Effective Capacitance, filed May 4, 2004, channels utilizing connectors that rely on either these teachings or those of the '358 patent can still exhibit unacceptably high alien NEXT at very high frequencies (e.g., 500 MHz). As such, it would be desirable to provide connectors and channels used thereby with reduced alien NEXT at very high frequencies.

PCT Patent Application WO 03/090322 discloses a communications jack that includes a housing having a plug aperture, a wiring board and a plurality of contacts that are configured to mate with a plurality of contacts of a communications plug when the plug is inserted in the plug aperture. At least some of the contacts are electrically connected to respective ones of a plurality of conductive traces on the wiring board.

### Summary of the Invention

The present invention can provide communications jacks with improved differential to common mode and differential to differential NEXT and FEXT performance, particularly at high frequencies. The present invention includes a communications jack according to independent claim 1. Further, embodiments of the invention may be realized in accordance with the dependent claims.

As noted above, the wiring board is a "floating" wiring board that is suspended from the mounting substrate. This configuration enables the wiring board to move with the conductors when they deflect in response interconnection with another connector.

### Brief Description of the Figures

Figure 1 is an exploded perspective view of a prior art communications jack.
Figure 1A is an enlarged perspective view of the prior art communications jack of Figure 1.
Figure 1B is a top view of the wiring board of Figure 1A.
Figure 2 is a side view of contact wires of the jack of Figure 1.
Figure 3 is a top schematic view of contact wires of the prior art jack of Figure 1.
Figure 4 is a top schematic view of conductors of an embodiment of a communications jack according to the present invention.
Figure 5 is a perspective view of a communications jack that includes the conductors of Figure 4 according to embodiments of the present invention.
Figure 6 is an enlarged perspective view of the communications jack of Figure 5.
Figure 7 is a partial side view of the jack of Figure 6.
**Figure 8** is a partial top view of the jack of **Figure 6****.**
**Figure 9** is an enlarged perspective view of the floating printed wiring board of the jack of **Figure 6****.**

### Detailed Description of Embodiments of the Invention

The present invention will be described more particularly hereinafter with reference to the accompanying drawings. The invention is not intended to be limited to the illustrated embodiments; rather, these embodiments are intended to fully and completely disclose the invention to those skilled in this art. In the drawings, like numbers refer to like elements throughout. Thicknesses and dimensions of some components may be exaggerated for clarity.

It will be understood that when an element is referred to as being "coupled" or "connected" to another element, it can be directly coupled or connected to the other element or intervening elements may also be present. In contrast, when an element is referred to as being "directly coupled" or "directly connected" to another element, there are no intervening elements present. Like numbers refer to like elements throughout. As used herein the term "and/or" includes any and all combinations of one or more of the associated listed items.

In addition, spatially relative terms, such as "under", "below", "lower", "over", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

Well-known functions or constructions may not be described in detail for brevity and/or clarity.

As used herein the expression "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

This invention is directed to communications connectors, with a primary example of such being a communications jack. As used herein, the terms "forward", "forwardly", and "front" and derivatives thereof refer to the direction defined by a vector extending from the center of the jack toward the plug opening of the jack. Conversely, the terms "rearward", "rearwardly", and derivatives thereof refer to the direction directly opposite the forward direction; the rearward direction is defined by a vector that extends away from the plug opening toward the remainder of the jack. The terms "lateral," "laterally", and derivatives thereof refer to the direction generally parallel with the plane defined by a wiring board on which jack contact wires are mounted and extending away from a plane bisecting the plug in the center. The terms "medial," "inward," "inboard," and derivatives thereof refer to the direction that is the converse of the lateral direction, i.e., the direction parallel with the plane defined by the wiring board and extending from the periphery of the jack toward the aforementioned bisecting plane. Where used, the terms "attached", "connected", "interconnected", "contacting", "mounted" and the like can mean either direct or indirect attachment or contact between elements, unless stated otherwise. Where used, the terms "coupled," "induced" and the like can mean non-conductive interaction, either direct or indirect, between elements or between different sections of the same element, unless stated otherwise.

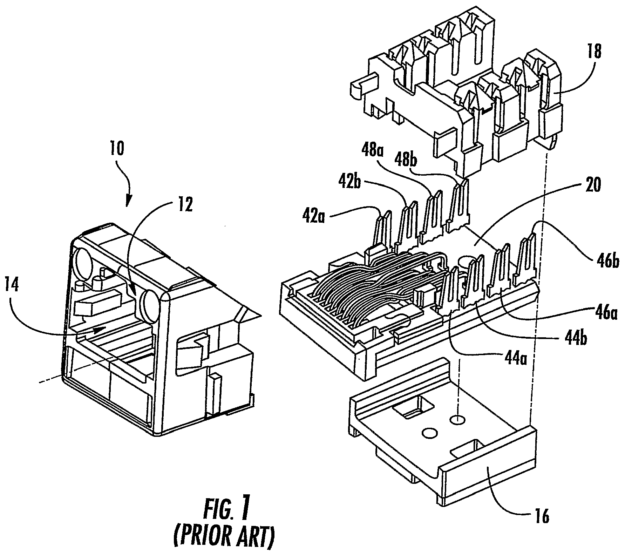

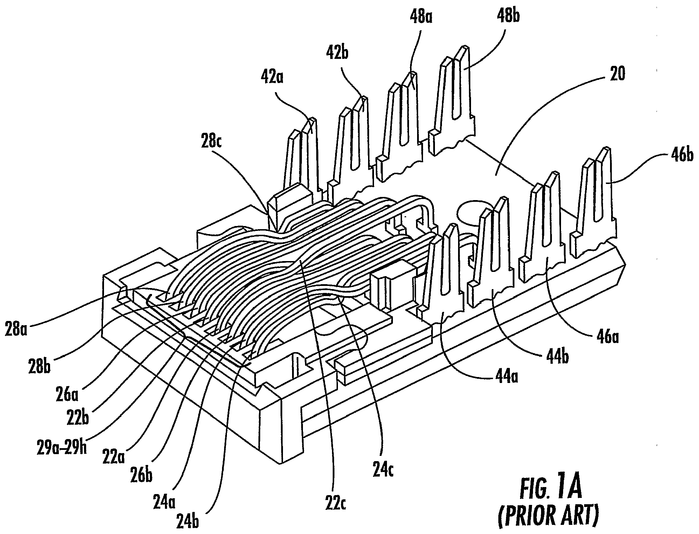

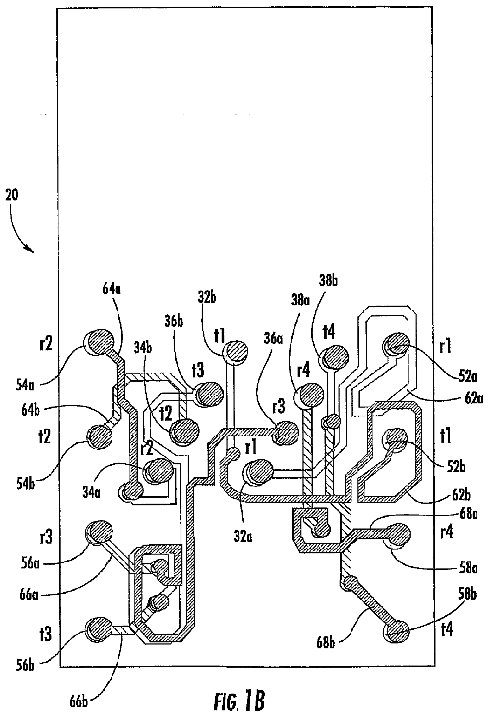

Referring now to the figures, a prior art jack, designated broadly at 10, is illustrated in Figures 1 and 1A. The jack 10 includes a jack frame 12 having a plug aperture 14 for receiving a mating plug, a cover 16 and a terminal housing 18. These components are conventionally formed and not need be described in detail herein; for a further description of these components and the manner in which they interconnect, see U.S. Patent No. 6,350,158 to Arnett et al., the disclosure of which is hereby incorporated herein in its entirety. Those skilled in this art will recognize that other configurations of jack frames, covers and terminal housings may also be employed with the present invention. Exemplary configurations are illustrated in U.S. Patent Nos. 5,975,919 and 5,947,772 to Arnett et al. and U.S. Patent No. 6,454,541 to Hashim et al.

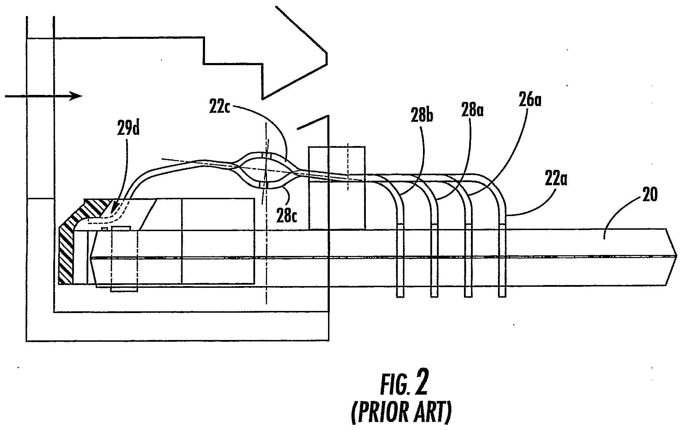

In addition, referring still to Figure 1 and also to Figure 2, the jack 10 further includes a wiring board 20 formed of conventional materials. The wiring board 20 may be a single layer board or may have multiple layers. The wiring board 20 may be substantially planar as illustrated, or may be non-planar.

Referring again to Figures 1 and 1A, contact wires 22a, 22b, 24a, 24b, 26a, 26b, 28a, 28b are attached to the wiring board 20. As described in U.S. Patent No. 6,350,158 referenced above, the contact wires 22a, 22b, 24a, 24b, 26a, 26b, 28a, 28b have free ends that have substantially the same profile, are substantially transversely aligned in side-by-side relationship, and that extend into the plug aperture 14 to form electrical contact with the terminal blades of a mating plug. The free ends of the contact wires 22a, 22b, 24a, 24b, 26a, 26b, 28a, 28b extend into individual slots 29a-29h in the forward edge portion of the wiring board 20. The contact wires 22a, 22b, 24a, 24b, 26a, 26b, 28a, 28b are arranged in pairs defined by TIA 568B, with wires 22a, 22b (pair 1) being adjacent to each other and in the center of the sequence of wires, wires 24a, 24b (pair 2) being adjacent to each other and occupying the leftmost two positions (from the vantage point of Figure 1B) in the sequence, wires 28a, 28b (pair 4) being adjacent to each other and occupying the rightmost two positions (from the vantage point of Figure 1B) in the sequence, and wires 26a, 26b (pair 3) being positioned between, respectively, pairs 1 and 4 and pairs 1 and 2. The wires 22a, 22b, 24a, 24b, 26a, 26b, 28a, 28b are mounted to the wiring board 20 via insertion into respective apertures 32a, 32b, 34a, 34b, 36a, 36b, 38a, 38b, which are arranged in the illustrated embodiment in a "dual diagonal" pattern known to those skilled in this art as described in U.S. Patent No. 6,196,880 to Goodrich et al. Those skilled in this art will appreciate that contact wires or other contacts of other configurations may be used. As one example, contact wires configured as described in aforementioned U.S. Patent No. 5,975,919 to Arnett et al. may be employed.

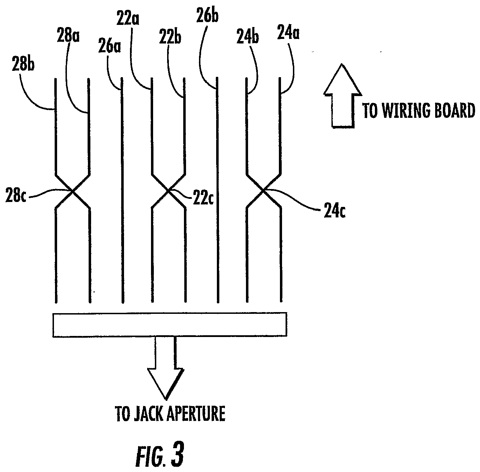

As can be seen in Figures 1A and 3, each of pairs 1, 2 and 4 that comprise adjacent contact wires include a respective "crossover" 22c, 24c, 28c, i.e., a location in which the contact wires of a pair cross each other without making electrical contact, typically such that the free end of one contact wire of the pair is substantially longitudinally aligned with the fixed end portion of the other contact wire of the pair. The crossovers 22c, 24c, 28c are located approximately in the center of their contact wires (between the free ends of the contact wires and their mounting locations on the wiring board 20). Crossovers are included to provide compensatory crosstalk between contact wires. In the illustrated embodiment, the crossovers are implemented via complementary localized bends in the crossing wires, with one wire being bent upwardly and the other wire being bent downwardly. The presence of a crossover, structural implementations thereof, and its effect on crosstalk are discussed in some detail in the '358 patent described above and U.S. Patent No. 5,186,647 to Denkmann et al. In this prior art device, the contact wires of pair 3 (wires 26a, 26b) do not include a crossover.

Referring once again to Figures 1 and 1A and to Figure 1B, eight insulation displacement connectors (IDCs) 42a, 42b, 44a, 44b, 46a, 46b, 48a, 48b are inserted into eight respective IDC apertures 52a, 52b, 54a, 54b, 56a, 56b, 58a, 58b. The IDCs are of conventional construction and need not be described in detail herein; exemplary IDCs are illustrated and described in U.S. Patent No. 5,975,919 to Arnett.

Referring now to Figures 1A, 1B and 2, the each of the wire apertures 32a, 32b, 34a, 34b, 36a, 36b, 38a, 38b is electrically connected to a respective IDC aperture 52a, 52b, 54a, 54b, 56a, 56b, 58a, 58b via a respective conductor 62a, 62b, 64a, 64b, 66a, 66b, 68a, 68b, thereby interconnecting each of the contact wires 22a, 22b, 24a, 24b, 26a, 26b, 28a, 28b to its corresponding IDC 42a, 42b, 44a, 44b, 46a, 46b, 48a, 48b. The conductors 62a, 62b, 64a, 64b, 66a, 66b, 68a, 68b are formed of conventional conductive materials and are deposited on the wiring board 20 via any deposition method known to those skilled in this art to be suitable for the application of conductors. Some conductors are illustrated as being entirely present on a single layer of the wiring board 20 (for example, conductor 62a), while other conductors (for example, conductor 62b) may reside on multiple layers of the wiring board 20; conductors can travel between layers through the inclusion of vias (also known as plated through holes) or other layer-transferring structures known to those skilled in this art.

U.S. Patent No. 5,967,853 to Hashim describes a technique whereby capacitive compensation is used to simultaneously compensate differential to differential and differential to common mode crosstalk. However, in order to effectively cancel both NEXT and FEXT it is typically necessary to provide both inductive and capacitive compensation. The prior art arrangement of contact wires disclosed in Figures 1-3 has been proven to effectively and efficiently provide inductive differential to differential crosstalk compensation. However, it has been determined that this arrangement may be ineffective, and perhaps counterproductive, in providing inductive differential to common mode compensation in the jack 10. More specifically, the prior art arrangement provides inductive differential to differential crosstalk compensation between pairs 1 and 3, pairs 2 and 3, and pairs 4 and 3, but in the development of the present invention it has been recognized that, due to the large physical separation between the conductors of pair 3 and their asymmetric placement relative to pair 2 (and similarly to pair 4), the highest levels of differential to common mode crosstalk in a mating plug, which can be the most problematic to channel performance, tend to occur on pairs 2 and 4 when pair 3 is excited differentially. The differential to common mode crosstalk occurring when any of the pairs 1, 2 and 4 is excited differentially tends to be much less severe, and consequently much less problematic, because the separation between the conductors in each of these pairs is one-third the separation between the conductors of pair 3. In the prior art arrangement of contact wires disclosed in Figures 1-3, crossover on each of pairs 1, 2 and 4 inductively compensates for the less severe differential to common mode crosstalk occurring when any of these pairs is differentially excited. However, due to the absence of a crossover on pair 3, this arrangement not only fails to inductively compensate for the more severe common mode crosstalk on pairs 2 and 4 when pair 3 is differentially excited, but can actually exacerbate this problem. This is especially true when the jack receives a conventional plug such as the one illustrated in U.S. Patent No. 6,250,949 to Lin.

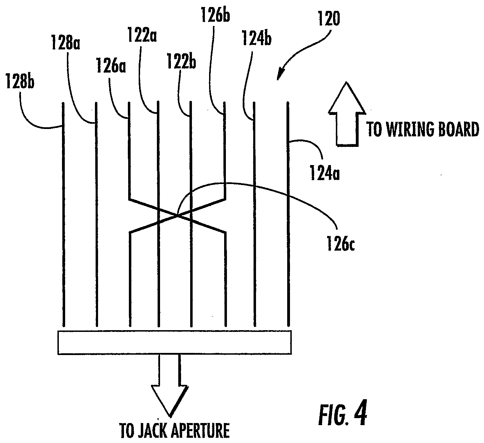

Turning now to Figure 4, an arrangement of wires according to embodiments of the present invention, designated broadly at 120, is illustrated schematically therein. The wiring arrangement 120 includes eight contact wires 122a, 122b, 124a, 124b, 126a, 126b, 128a, 128b that comprise, respectively, wire pairs 1, 2, 3 and 4. In contrast to the prior art arrangement of contact wires described above, in this embodiment the contact wires 122a, 122b of pair 1, the contact wires 124a, 124b of pair 2, and the contact wires 128a, 128b of pair 4 do not include a crossover, while the contact wires 126a, 126b include a crossover 126c.

Like the prior arrangement, this arrangement of contact wires should provide compensatory inductive differential to differential crosstalk between pairs 1 and 3, pairs 2 and 3, and pairs 4 and 3. In addition, this arrangement, although not inductively compensating for the less severe differential to common mode crosstalk occurring when any of the pairs 1, 2 and 4 is differentially excited, can provide inductive compensation for the highly problematic differential to common mode crosstalk occurring on pairs 2 and 4 when pair 3 is differentially excited. Because the most problematic differential to common mode crosstalk can be inductively compensated, a jack employing this arrangement can meet higher performance standards, particularly at elevated frequencies.

One exemplary implementation of this arrangement is illustrated and described in co- assigned and co-pending U.S. Patent Application Serial No. 11/044,088, filed March 25, 2005. The implementation illustrated therein employs supports posts that support the contact wires of pair 3 as they cross over and under the wires of pair 1. However, there may be some manufacturing difficulties with this implementation.

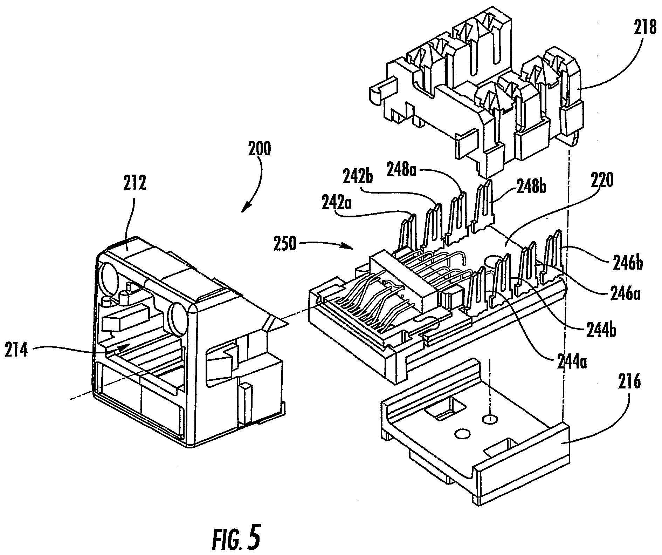

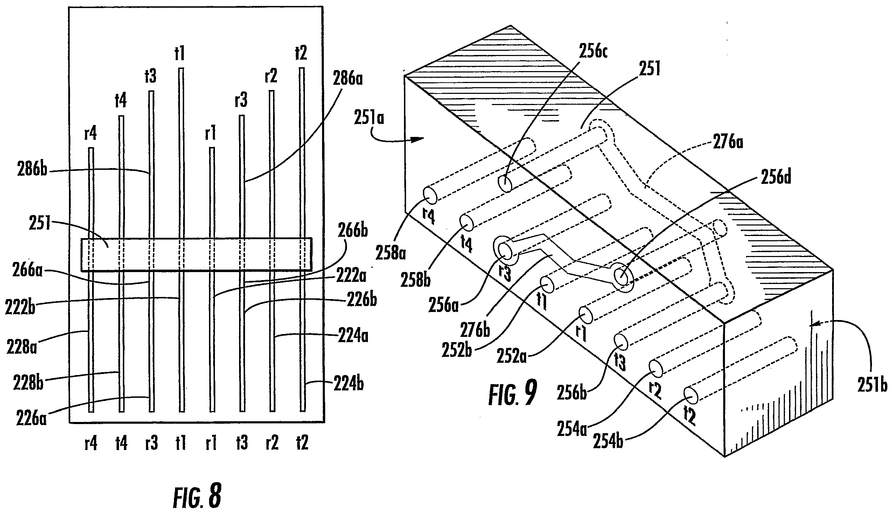

Another exemplary implementation of the arrangement of Figure 4 is illustrated in Figures 5-9, in which a jack 200 according to embodiment of the present invention is shown. The jack 200 includes a jack frame 212 having a plug aperture 214, a cover 216 and a terminal housing 218. A wiring board 220 includes IDCs 242a-248b mounted thereon. Conductors 222a-228b in the form of contact wires are mounted to the wiring board 220 in side-by-side and generally parallel relationship. As used herein, "generally parallel" with reference to the conductors means that, from the vantage point of **Figure 8****,** substantial portions of the conductors are parallel to one another. Conductors that are "aligned" have free and fixed ends that are substantially collinear from the vantage point of **Figure 8****,** and conductors that are "non-aligned" have free and fixed ends that are not substantially collinear from the vantage point of **Figure 8****.**

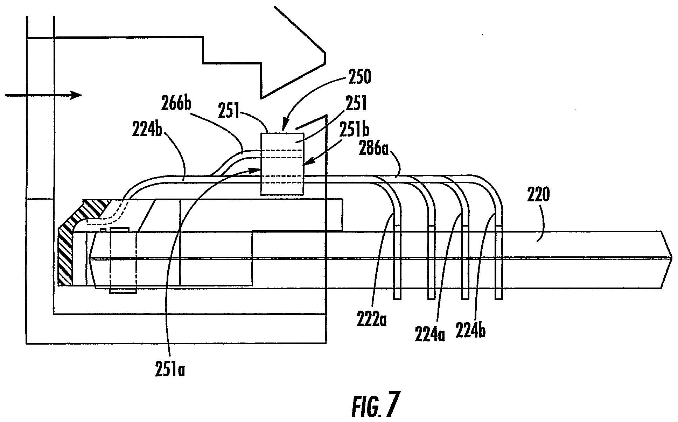

At their free ends, the conductors **222a-228b** fit within slots **229a-229h** located at the forward end of the wiring board **220** and are positioned to mate with the blades of a plug inserted into the plug aperture **214.** With the exception of the crossover region **250,** described in greater detail below, the conductors **222a-228b** follow generally the same profile (from the vantage point of **Figure 7**) until they bend downwardly into their respective mounting apertures in the wire board **220.** Conductive traces on the wiring board **220** provide signal paths between the conductors **222a-228b** and the IDCs **242a-248b.**

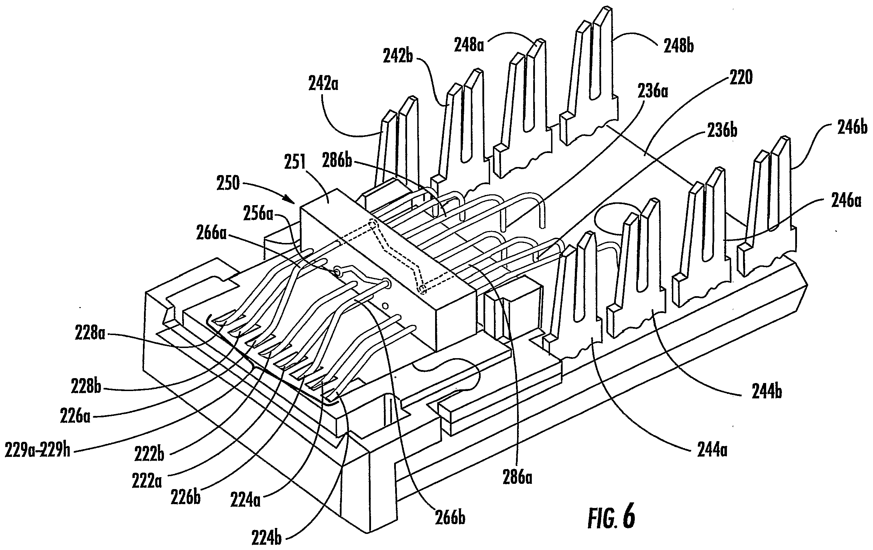

Referring now to **Figures 6-9****,** the crossover region **250** includes a "floating" printed wiring board (PWB) **251** that is suspended above the wiring board **220** by the conductors **222a-228b** and is generally perpendicular to the wiring board **220** and the conductors **222a-228b.** In the illustrated embodiment, the lower edge of the PWB **251** is spaced apart from the upper surface of the wiring board **220,** such that the PWB **251** is free to move upon deflection of the conductors **222a-228b** (as when a mating plug is inserted into the jack **200**), although in some embodiments the lower edge of the PWB **251** may contact the wiring board **220,** and in other embodiments there may be a clearance opening in the wiring board **220** to permit the lower edge of PWB **251** to move to a position below the upper surface of the wiring board **220.** The distance between the PWB **251** and the locations where the conductors **222a, 222b** intercept a mating plug is about 0.154 inches, but those skilled in this art will appreciate that a different distance may also be suitable with the present invention. Typically the conductors are between about 0.648 and 0.828 inches in length, and the crossover region **250** occurs between about 0.3 and 0.4 inches from the free ends of the contact wires **222a-228b.**

Referring now to **Figure 9****,** the PWB **251,** which can be rigid or flexible and is typically formed of a dielectric material, includes eight bores **252a, 252b, 254a, 254b, 256a, 256b, 258a, 258b** in a lower row, and two bores **256c, 256d** in an upper row that extend from the front surface **251a** of the PWB **251** to the rear surface **251b** thereof. Six of the conductors, namely those that comprise pairs 1, 2 and 4 (i.e., conductors **222a, 222b, 224a, 224b, 228a, 228b**) pass directly through respective bores **252a, 252b, 254a, 254b, 258a,** 258b, and follow relatively straight paths (see **Figures 7** and **8**). The PWB **251** is sized such that its lower edge is spaced from the upper surface of the wiring board **220** (hence the term "floating" PWB). The bores **252a, 252b, 254a, 254b, 258a, 258b** are sized such that the conductors passing therethrough can slide relative to the PWB **251.**

In contrast to the other conductors, each of the conductors **226a, 226b** of pair 3 includes an approaching segment **266a, 266b** that veers upwardly from the path defined by the other conductors and passes into a respective bore **256c, 256d** of the upper row of bores. Also, each of the conductors **226a, 226b** includes an exiting segment **286a, 286b** that exits a respective bore **256a, 256b** and travels therefrom to the wiring board **220** (each of the exiting segments **286a, 286b** follows generally the profile of, respectively, the conductors **228b, 224a** as they exit the PWB **251**). The bores **256a, 256b** are plated with a conductive material. All of the bores **256a-256d** are sized for a snug fit with their respective segments.

The front surface **251a** of the PWB **251** includes a conductive trace **276b** that extends between the bore **256d** of the upper row of bores and the bore **256a** of the lower row of bores (notably, the path followed by the trace **276b** crosses over the conductors **222a, 222b** of pair 1). Thus, a conductive path for the conductor **226b** is created between the approaching segment **266b,** the conductive trace **276b,** the bore **256a,** and the exiting segment **286b.** Similarly, the rear surface **251b** of the PWB **251** includes a conductive trace **276a** that extends between the bore **256c** of the upper row of bores and the bore **256b** of the lower row of bores (and crosses over the conductors **222a, 222b**). Thus, a conductive path for the conductor **226a** is created between the approaching segment **266a,** the bore **256c,** the conductive trace **276a,** and the exiting segment **286a.** It can be seen that the conductive traces **276a, 276b** are electrically insulated from each other, which enables the conductors **226a, 226b** to cross without making electrical contact.

It can be seen that the conductive paths of the conductors **226a, 226b** (i.e., the conductors of pair 3) are able to "cross over" each other (i.e., the free end of each of the conductors **226a, 226b** of pair 3 is aligned with the fixed end of the other conductor **226b, 226a** of pair 3), and the conductors of pair 1 in order to create the schematic arrangement shown in **Figure 4****.** Thus, the illustrated embodiment has the advantage of enabling the commencement of the inductive differential to differential and differential to common mode compensations at minimal delay from the corresponding crosstalk sources, which can be important to effective crosstalk compensation.

It should also be understood that a floating PWB may also be employed for generating cross-over configurations for other pairs of conductors. Furthermore, the floating PWB can be a multi-layer board with the crossover traces residing on any of its layers. It should also be understood that, rather than having selected conductors slide through bores on the floating PWB, any or all of these conductors can comprise approaching and exiting segments that fixedly terminate into plated bores on the PWB, with signal path completion achieved by conductive traces on the PWB or by conductive plating within a single bore. Moreover, it should be recognized that the PWB may be sized such that only the conductors of pairs 1 and 3 are captured therein, with the result that the conductors of pairs 2 and 4 simply extend unimpeded from free end to fixed end. Alternatively, the PWB and contacts can be sized or shaped such that only the conductors of pair 3 are captured, with the result that conductors of pairs 1, 2 and 4 simply extend unimpeded from free end to fixed end. In addition, the PWB may include other devices, such as parallel plate or interdigital capacitors, that provide another stage of capacitive crosstalk compensation.

The skilled artisan will recognize that, although eight contact wires are illustrated and described herein, other numbers of contact wires may be employed. For example, 16 contact wires may be employed, and one or more crossovers that cross over a pair of contact wires sandwiched therebetween may be included in those contact wires.

Further, those skilled in this art will recognize that other jack configurations may also be suitable for use with the present invention. For example, as discussed above, other configurations of jack frames, covers and terminal housings may also be employed with the present invention. As another example, the contact wires may have a different profile (an exemplary alternative profile is depicted in U.S. Patent No. 5,975,919 to Arnett et al.), or they may mount in locations that do not follow the "dual diagonal" mounting scheme illustrated herein (an exemplary alternative in which the contact wires are staggered is illustrated in U.S. Patent No. 6,116,964 to Goodrich et al). As a further example, the IDCs may mount in a different pattern on the wiring board, or some other type of connector may be used. Those skilled in this art will also recognize that embodiments of the wiring board described above may be employed in other environments in which a communications jack may be found. For example, jacks within a patch panel or series of patch panels may be suitable for use with such wiring boards. Other environments may also be possible.

The configuration illustrated and described herein can provide connectors, and in particular communications jacks, that exhibit improved crosstalk characteristics, particularly at elevated frequencies. For example, a connector such as that illustrated in Figures 5-9 and mated with a conventional plug may have channel alien NEXT of less than -60 dB power sum at 100 MHz, and less than -49.5 dB power sum at 500 MHz.

Also those skilled in the art will recognize that, in situations in which it may not be critical to implement the differential to differential crosstalk compensation between pairs 3 and 2 and between pairs 3 and 4 in the contact wires, it is possible to provide instead compensation for the common mode crosstalk induced on pair 3, or pair 1, when either of pair 2 or pair 4 is differentially excited, by modifying the contact wire crossover scheme of Figure 4 to include crossovers in pairs 2 and 4 in addition to the crossover on pair 3.

Further, those skilled in the art will recognize the reciprocity that exists between the differential to common mode crosstalk induced on a first pair, when a second pair is excited differentially, and the common mode to differential signal induced on the second of these pairs when the first of these pairs is excited common-modally, with the common mode to differential crosstalk equaling the differential to common mode crosstalk multiplied by a constant, that constant being the ratio of the differential to common mode impedances. Consequently, when an improvement occurs, due to the current invention, in the differential to common mode crosstalk between two pairs when one of these pairs is excited differentially, a corresponding improvement occurs in the common mode to differential crosstalk between these two pairs, when the other of these pairs is excited common-modally.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims.

## Claims

1. A communications jack (200), comprising:
a housing (212, 216, 218) having a plug aperture (214);
a dielectric mounting substrate (220); and
a plurality of contacts (222a, 222b, 224a, 224b, 226a, 226b, 228a, 228b) mounted in the dielectric mounting substrate (220) that are configured to mate with respective ones of a plurality of contacts of a communications plug when the plug is inserted into the plug aperture (214), wherein each of the plurality of contacts (222a, 222b, 224a, 224b, 226a, 226b, 228a,
228b) includes a fixed end portion mounted in the dielectric mounting substrate (220) and a free end portion,
the communications jack (200) being **characterized in that** it further comprises:
a floating wiring board (251) mounted at least partially within the plug aperture (214) and positioned between the fixed and free end portions of the plurality of contacts (222a, 222b, 224a, 224b, 226a, 226b, 228a, 228b), the floating wiring board (251) being generally perpendicular to the plurality of contacts and suspended from the dielectric mounting substrate (220) by the plurality of contacts (222a, 222b, 224a, 224b, 226a, 226b, 228a, 228b);
wherein at least some of the plurality of contacts (222a, 222b, 224a, 224b, 226a, 226b, 228a, 228b) are electrically connected to respective ones of a plurality of conductive traces (276a, 276b) on the floating wiring board (251),
wherein a position of the floating wiring board (251) within the plug aperture (214) changes when the plug is inserted into the plug aperture (214), and
wherein a first of the plurality of contacts (222a, 222b, 224a, 224b, 226a, 226b, 228a, 228b) is electrically connected with a respective one of the plurality of conductive traces such that the fixed end portion and the free end portion of the first contact (222a, 222b, 224a, 224b, 226a, 226b, 228a, 228b) are in a non-aligned relationship.

2. The communications jack (200) of claim 1, wherein each of the free end portions is positioned in a side-by-side and generally parallel relationship, and each of the fixed end portions are positioned in a side-by-side and generally parallel relationship.

3. The communications jack of Claim 2, wherein the floating wiring board (251) comprises a flexible wiring board (251).

4. The communications jack of Claim 3, wherein the plurality of contacts (222a, 222b, 224a, 224b, 226a, 226b, 228a, 228b) comprises eight contacts (222a, 222b, 224a, 224b, 226a, 226b, 228a, 228b) that are configured as four differential pairs of contacts (222a, 222b; 224a, 224b; 226a, 226b; 228a, 228b), and wherein the conductive traces (276a, 276b) on the flexible wiring board (251) associated with at least one of the differential pairs cross over each other.

5. The communications jack of Claim 3, wherein the flexible wiring board (251) includes at least one capacitor.

6. The communications jack of Claim 2, wherein the floating wiring board (251) includes a first plated hole (256b) that receives a first intermediate end of a first of the plurality of contacts (226a), a second plated hole (256c) that receives a second intermediate end of the first of the plurality of contacts (226a), a first of the plurality of conductive traces (276b) electrically connects the first and second intermediate ends of the first of the plurality of contacts (226a), and the fixed end portion and the free end portion of the first of the plurality of contacts (226a) are in a non-aligned relationship.

7. The communications jack of Claim 6, wherein a second of the plurality of contacts (226b) is electrically connected with a second of the plurality of conductive traces (276a) such that the fixed end portion and the free end portion of the second of the plurality of contacts (226b) are in non-aligned relationship.

8. The communications jack of Claim 7, wherein the first of the plurality of contacts (226a) and the second of the plurality of contacts (226b) form a crossover on the floating wiring board (251).

9. The communications jack of Claim 7, wherein the first of the plurality of contacts (226a) and the second of the plurality of contacts (226b) sandwich a third of the plurality of contacts (222a) and a fourth of the plurality of contacts (222b).

10. The communications jack of Claim 7, wherein the floating wiring board (251) has multiple layers, and wherein the first of the plurality of conductive traces (276b) is positioned on a first layer, and the second of the plurality of conductive traces (276a) is positioned on a second layer.

11. The communications jack of Claim 9, wherein a fifth of the plurality of contacts (228a) and a sixth of the plurality of contacts (228b) are positioned adjacent the first of the plurality of contacts (226a), and a seventh of the plurality of contacts (224a) and an eighth of the plurality of contacts (224b) are positioned adjacent the second of the plurality of contacts (226b).

12. The communications jack of Claim 11, wherein the third of the plurality of contacts (222a) and the fourth of the plurality of contacts (222b) pass through bores in the floating wiring board (251).

13. The communications jack of Claim 11, wherein the fifth of the plurality of contacts (228a) and the sixth of the plurality of contacts (228b) are formed so as to not include a crossover, and the seventh of the plurality of contacts (224a) and the eighth of the plurality of contacts (224b) are formed so as to not include a crossover.

14. The communications jack of Claim 7, wherein the floating wiring board (251) is supported above the dielectric mounting substrate (220) by at least the first of the plurality of contacts (226a) and the second of the plurality of contacts (226b).

15. The communications jack of Claim 7, wherein the first of the plurality of contacts (226a) and the second of the plurality of contacts (226b) are between 0.648 and 0.828 inches in length, and wherein the floating wiring board (251) is positioned between 0.3 and 0.4 inches from the free end portions of the first of the plurality of contacts (226a) and the second of the plurality of contacts (226b).

16. The communications jack of Claim 1, wherein the dielectric mounting substrate (220) comprises a second wiring board.

## Patentansprüche

1. Kommunikationsverbinder (200), welcher umfasst:
ein Gehäuse (212, 216, 218), welches eine Steckerapertur (214) umfasst;
ein dielektrisches Einrichtungssubstrat (220); und
eine Mehrzahl von Kontakten (222a, 222b, 224a, 224b, 226a, 226b, 228a, 228b), welche in dem dielektrischen Einrichtungssubstrat (220) eingerichtet sind, welche dazu konfiguriert sind, sich mit jeweiligen einer Mehrzahl von Kontakten von einem Kommunikationsstecker zu paaren, wenn der Stecker in der Steckerapertur (214) eingesteckt ist, wobei jeder der Mehrzahl von Kontakten (222a, 222b, 224a, 224b, 226a, 226b, 228a, 228b) einen fixierten Endabschnitt, welcher in dem dielektrischen Einrichtungssubstrat (220) eingerichtet ist, und
einen freien Endabschnitt enthält,
wobei der Kommunikationsverbinder (200) **dadurch gekennzeichnet ist, dass** er ferner enthält:
eine potenzialfreie Leiterplatte (251), welche zumindest teilweise innerhalb der Steckerapertur (214) eingerichtet ist und zwischen dem fixierten und freien Endabschnitt der Mehrzahl von Kontakten (222a, 222b, 224a, 224b, 226a, 226b, 228a, 228b) angeordnet ist, wobei die potenzialfreie Leiterplatte (251) im Allgemeinen senkrecht zu der Mehrzahl von Kontakten verläuft und durch die Mehrzahl von Kontakten (222a, 222b, 224a, 224b, 226a, 226b, 228a, 228b) gegenüber dem dielektrischen Einrichtungssubstrat (220) verschoben ist;
wobei zumindest einige der Mehrzahl von Kontakten (222a, 222b, 224a, 224b, 226a, 226b, 228a, 228b) mit jeweiligen einer Mehrzahl von Leiterbahnen (276a, 276b) auf der potenzialfreien Leiterplatte (251) elektrisch verbunden sind,
wobei sich eine Position von der potenzialfreien Leiterplatte (251) innerhalb der Steckerapertur (214) ändert, wenn der Stecker in die Steckerapertur (214) eingesteckt ist, und
wobei ein erster der Mehrzahl von Kontakten (222a, 222b, 224a, 224b, 226a, 226b, 228a, 228b) mit einer jeweiligen der Mehrzahl von Leiterbahnen derart elektrisch verbunden ist, dass der fixierte Endabschnitt und der freie Endabschnitt von dem ersten Kontakt (222a, 222b, 224a, 224b, 226a, 226b, 228a, 228b) in einer nicht ausgerichteten Beziehung zueinander stehen.

2. Kommunikationsverbinder (200) nach Anspruch 1, wobei jeder von den freien Endabschnitten in einer nebeneinander angeordneten und im Allgemeinen parallelen Beziehung angeordnet ist, und wobei jeder von den fixierten Endabschnitten in einer nebeneinander angeordneten und im Allgemeinen parallelen Beziehung angeordnet ist.

3. Kommunikationsverbinder nach Anspruch 2, wobei die potenzialfreie Leiterplatte (251) eine flexible Leiterplatte (251) enthält.

4. Kommunikationsverbinder nach Anspruch 3, wobei die Mehrzahl von Kontakten (222a, 222b, 224a, 224b, 226a, 226b, 228a, 228b) acht Kontakte (222a, 222b, 224a, 224b, 226a, 226b, 228a, 228b) enthält, welche zu vier Differentialpaaren von Kontakten (222a, 222b; 224a, 224b; 226a, 226b; 228a, 228b) konfiguriert sind, und wobei die Leiterbahnen (276a, 276b) auf der flexiblen Leiterplatte (251), welche mit zumindest einem der Differentialpaare in Zusammenhang stehen, einander überkreuzen.

5. Kommunikationsverbinder nach Anspruch 3, wobei die flexible Leiterplatte (251) zumindest einen Kondensator enthält.

6. Kommunikationsverbinder nach Anspruch 2, wobei die potenzialfreie Leiterplatte (251) ein erstes metallisiertes Loch (256b), welches ein erstes Zwischenende von einem ersten der Mehrzahl von Kontakten (226a) aufnimmt, ein zweites metallisiertes Loch (256c), welches ein zweites Zwischenende von dem ersten der Mehrzahl von Kontakten (226a) aufnimmt, enthält, wobei eine erste der Mehrzahl von Leiterbahnen (276b) das erste und zweite Zwischenende von dem ersten der Mehrzahl von Kontakten (226a) elektrisch miteinander verbindet, und wobei der fixierte Endabschnitt und der freie Endabschnitt von dem ersten der Mehrzahl von Kontakten (226a) in einer nicht ausgerichteten Beziehung zueinander stehen.

7. Kommunikationsverbinder nach Anspruch 6, wobei ein zweiter der Mehrzahl von Kontakten (226b) mit einer zweiten der Mehrzahl von Leiterbahnen (276a) derart elektrisch verbunden ist, dass der fixierte Endabschnitt und der freie Endabschnitt von dem zweiten der Mehrzahl von Kontakten (226b) in einer nicht ausgerichteten Beziehung zueinander stehen.

8. Kommunikationsverbinder nach Anspruch 7, wobei der erste der Mehrzahl von Kontakten (226a) und der zweite der Mehrzahl von Kontakten (226b) auf der potenzialfreien Leiterplatte (251) eine Überkreuzung ausbilden.

9. Kommunikationsverbinder nach Anspruch 7, wobei der erste der Mehrzahl von Kontakten (226a) und der zweite der Mehrzahl von Kontakten (226b) einen dritten der Mehrzahl von Kontakten (222a) und einen vierten der Mehrzahl von Kontakten (222b) zwischenlegen.

10. Kommunikationsverbinder nach Anspruch 7, wobei die potenzialfreie Leiterplatte (251) mehrere Schichten enthält, und wobei die erste der Mehrzahl von Leiterbahnen (276b) auf einer ersten Schicht angeordnet ist und die zweite der Mehrzahl von Leiterbahnen (276a) auf einer zweiten Schicht angeordnet ist.

11. Kommunikationsverbinder nach Anspruch 9, wobei ein fünfter der Mehrzahl von Kontakten (228a) und ein sechster der Mehrzahl von Kontakten (228b) angrenzend zu dem ersten der Mehrzahl von Kontakten (226a) angeordnet sind, und wobei ein siebter der Mehrzahl von Kontakten (224a) und ein achter der Mehrzahl von Kontakten (224b) angrenzend zu dem zweiten der Mehrzahl von Kontakten (226b) angeordnet sind.

12. Kommunikationsverbinder nach Anspruch 11, wobei der dritte der Mehrzahl von Kontakten (222a) und der vierte der Mehrzahl von Kontakten (222b) durch Bohrungen in der potenzialfreien Leiterplatte (251) durchlaufen.

13. Kommunikationsverbinder nach Anspruch 11, wobei der fünfte der Mehrzahl von Kontakten (228a) und der sechste der Mehrzahl von Kontakten (228b) derart ausgebildet sind, dass sie sich einander nicht überkreuzen, und wobei der siebte der Mehrzahl von Kontakten (224a) und der achte der Mehrzahl von Kontakten (224b) derart ausgebildet sind, dass sie sich einander nicht überkreuzen.

14. Kommunikationsverbinder nach Anspruch 7, wobei die potenzialfreie Leiterplatte (251) durch zumindest den ersten der Mehrzahl von Kontakten (226a) und den zweiten der Mehrzahl von Kontakten (226b) oberhalb des dielektrischen Einrichtungssubstrats (220) gelagert ist.

15. Kommunikationsverbinder nach Anspruch 7, wobei der erste der Mehrzahl von Kontakten (226a) und der zweite der Mehrzahl von Kontakten (226b) eine Länge zwischen 0,648 und 0,828 Zoll haben, und wobei die potenzialfreie Leiterplatte (251) zwischen 0,3 und 0,4 Zoll von den freien Endabschnitten des ersten der Mehrzahl von Kontakten (226a) und des zweiten der Mehrzahl von Kontakten (226b) angeordnet ist.

16. Kommunikationsverbinder nach Anspruch 1, wobei das dielektrische Einrichtungssubstrat (220) eine zweite Leiterplatte enthält.

## Revendications

1. Connecteur de communications (200), comprenant :
un boîtier (212, 216, 218) ayant une ouverture pour prise (214) ;
un substrat de montage diélectrique (220) ; et
une pluralité de contacts (222a, 222b, 224a, 224b, 226a, 226b, 228a, 228b) montés dans le substrat de montage diélectrique (220), qui sont configurés pour s'accoupler avec des contacts respectifs d'une pluralité de contacts d'une prise de communication quand la prise est insérée dans l'ouverture pour prise (214), dans lequel chacun de la pluralité de contacts (222a, 222b, 224a, 224b, 226a, 226b, 228a, 228b) inclut une portion terminale fixe montée dans le substrat de montage diélectrique (220) et une portion terminale libre,
le connecteur de communication (200) étant **caractérisé en ce qu'**il comprend en outre :
une carte de câblage flottante (251) montée au moins partiellement à l'intérieur de l'ouverture pour prise (214) et positionnée entre la portion terminale fixe et la portion terminale libre de la pluralité de contacts (222a, 222b, 224a, 224b, 226a, 226b, 228a, 228b), la carte de câblage flottante (251) étant généralement perpendiculaire à la pluralité de contacts et suspendue depuis le substrat de montage diélectrique (220) par la pluralité de contacts (222a, 222b, 224a, 224b, 226a, 226b, 228a,228b);
dans lequel au moins certains de la pluralité de contacts (222a, 222b, 224a, 224b, 226a, 226b, 228a, 228b) sont électriquement connectés à des pistes respectives d'une pluralité de pistes conductrices (276a, 276b) sur la carte de câblage flottante (251),
dans lequel une position de la carte de câblage flottante (251) à l'intérieur de l'ouverture pour prise (214) change quand la prise est introduite dans l'ouverture pour prise (214), et
dans lequel un premier de la pluralité de contacts (222a, 222b, 224a, 224b, 226a, 226b, 228a, 228b) est électriquement connecté avec une piste respective de la pluralité de pistes conductrices de telle façon que la portion terminale fixe et la portion terminale libre du premier contact (222a, 222b, 224a, 224b, 226a, 226b, 228a, 228b) sont dans une relation non alignée.

2. Connecteur de communications (200) selon la revendication 1, dans lequel chacune des portions terminales libres est positionnée dans une relation côte à côte et généralement parallèle, et chacune des portions terminales fixes est positionnée dans une relation côte à côte et généralement parallèle.

3. Connecteur de communications selon la revendication 2, dans lequel la carte de câblage flottante (251) comprend une carte de câblage flexible (251).

4. Connecteur de communications selon la revendication 3, dans lequel la pluralité de contacts (222a, 222b, 224a, 224b, 226a, 226b, 228a, 228b) comprend huit contacts (222a, 222b, 224a, 224b, 226a, 226b, 228a, 228b) qui sont configurés comme quatre paires différentielles de contacts (222a, 222b ; 224a, 224b ; 226a, 226b ; 228a, 228b), et dans lequel les pistes conductrices (276a, 276b) sur la carte de câblage flexible (251) associées à l'une au moins des paires différentielles se croisent mutuellement.

5. Connecteur de communications selon la revendication 3, dans lequel la carte de câblage flexible (251) inclut au moins une capacité.

6. Connecteur de communications selon la revendication 2, dans lequel la carte de câblage flottante (251) inclut un premier trou métallisé (256b) qui reçoit une première extrémité intermédiaire d'un premier de la pluralité de contacts (226a), un second trou métallisé (256c) qui reçoit une seconde extrémité intermédiaire du premier de la pluralité de contacts (226a), une première de la pluralité de pistes conductrices (276b) connecte électriquement la première et la seconde extrémité intermédiaire du premier de la pluralité de contacts (226a), et la portion terminale fixe et la portion terminale libre du premier de la pluralité de contacts (226a) sont dans une relation non alignée.

7. Connecteur de communications selon la revendication 6, dans lequel un second de la pluralité de contacts (226b) est électriquement connecté avec une seconde de la pluralité de pistes conductrices (276a) de telle façon que la portion terminale fixe et la portion terminale libre du second de la pluralité de contacts (226b) sont dans une relation non alignée.

8. Connecteur de communications selon la revendication 7, dans lequel le premier de la pluralité de contacts (226a) et le second de la pluralité de contacts (226b) forment une traversée sur la carte de câblage flottante (251).

9. Connecteur de communications selon la revendication 7, dans lequel le premier de la pluralité de contacts (226a) et le second de la pluralité de contacts (226b) prennent en sandwich un troisième de la pluralité de contacts (222a) et un quatrième de la pluralité de contacts (222b).

10. Connecteur de communications selon la revendication 7, dans lequel la carte de câblage flottante (251) comprend une multiplicité de couches, et dans lequel la première de la pluralité de pistes conductrices (276b) est positionnée sur une première couche, et la seconde de la pluralité de pistes conductrices (276a) est positionnée sur une seconde couche.

11. Connecteur de communications selon la revendication 9, dans lequel un cinquième de la pluralité de contacts (228a) et un sixième de la pluralité de contacts (228b) sont positionnés adjacents au premier de la pluralité de contacts (226a), et un septième de la pluralité de contacts (224a) et un huitième de la pluralité de contacts (224b) sont positionnés adjacents au second de la pluralité de contacts (226b).

12. Connecteur de communications selon la revendication 11, dans lequel le troisième de la pluralité de contacts (222a) et le quatrième de la pluralité de contacts (222b) passe à travers des perçages dans la carte de câblage flottante (251).

13. Connecteur de communications selon la revendication 11, dans lequel le cinquième de la pluralité de contacts (228a) et le sixième de la pluralité de contacts (228b) sont formés de manière à ne pas inclure une traversée, et le septième de la pluralité de contacts (224a) et le huitième de la pluralité de contacts (224b) sont formés de manière à ne pas inclure une traversée.

14. Connecteur de communications selon la revendication 7, dans lequel la carte de câblage flottante (251) est supportée au-dessus du substrat de montage diélectrique (220) au moins par le premier de la pluralité de contacts (226a) et par le second de la pluralité de contacts (226b).

15. Connecteur de communications selon la revendication 7, dans lequel le premier de la pluralité de contacts (226a) et le second de la pluralité de contacts (226b) ont une longueur entre 0,648 et 0,828 pouces, et dans lequel la carte de câblage flottante (251) est positionnée entre 0,3 et 0,4 pouces depuis les portions terminales libres du premier de la pluralité de contacts (226a) et du second de la pluralité de contacts (226b).

16. Connecteur de communications selon la revendication 1, dans lequel le substrat de montage diélectrique (220) comprend une seconde carte de câblage.
